# EUROPÄISCHE PATENTSCHRIFT

(11) **EP 0 769 205 B1**
(45) Veröffentlichungstag und Bekanntmachung des Hinweises auf die Patenterteilung: **17.04.2002**
(21) Anmeldenummer: 96902801.8
(22) Anmeldetag: 28.02.1996
(51) Int. Cl.: H01L 21/00

(54) **VORRICHTUNG ZUM BEHANDELN SCHEIBENFÖRMIGER GEGENSTÄNDE, INSBESONDERE SILICIUMWAFER**
DEVICE FOR TREATING WAFER-SHAPED OBJECTS, ESPECIALLY SILICON WAFERS
DISPOSITIF PERMETTANT DE TRAITER DES OBJETS SE PRESENTANT SOUS FORME DE TRANCHES, PAR EXEMPLE DES TRANCHES DE SILICIUM

(30) Priorität: 02.05.1995 AT 75395
(43) Veröffentlichungstag der Anmeldung: 23.04.1997
(73) Patentinhaber: SEZ Semiconductor-Equipment Zubehör für die Halbleiterfertigung AG, 9500 Villach (AT)
(72) Erfinder: SUMNITSCH, Franz, A-9020 Klagenfurt (AT)
(74) Vertreter: Hehenberger, Reinhard, Dipl.-Ing.
(86) Internationale Anmeldenummer: AT9600034
(87) Internationale Veröffentlichungsnummer: WO9635227

(56) Entgegenhaltungen:
- EP-A- 0 402 900
- EP-A- 0 444 714
- EP-A- 0 635 872
- DE-A- 4 232 902
- US-A- 4 788 994
- US-A- 5 168 886
- IBM TECHNICAL DISCLOSURE BULLETIN, Bd. 37, Nr. 09, September 1994, NEW YORK US, Seiten 623-624, XP000473530 "locking pin design for double-sided brush clean tool"

## Beschreibung

Die Erfindung betrifft eine Vorrichtung zum Behandeln scheibenförmiger Gegenstände mit den Merkmalen des einleitenden Teils des unabhängigen Anspruches 1.

Vorrichtungen für das Halten von scheibenförmigen Gegenständen, insbesondere von Siliziumwafern, sind in verschiedenen Ausführungsformen bekannt geworden.

Neben Trägern für Siliziumwafer, die nach dem Bernoulli-Prinzip arbeiten (sh. beispielsweise EP-A-0 316 296 und EP-A-0 444 714), ist aus der DE-A-42 32 902 ein Halter zum Transport von flachen, kreisscheibenförmigen Substraten bekannt geworden, der federnde Haltefinger aufweist, die in der Ebene von Spanngliedern einer Transportzange angeordnet sind. Die aus der DE-A-42 32 902 bekannte Vorrichtung dient aber ausschließlich zum Transport von kreisscheibenförmigen Gegenständen in einer Vakuumprozeßanlage.

Ein Träger für Halbleiterwafer mit am Außenumfang von Siliziumwafern angreifenden Halteteilen ist aus der US-A-5 168 886 bekannt. Mit Hilfe dieses Trägers können die Halbleiterwafer auch in Drehung versetzt werden. Allerdings ist bei dem aus der US-A-5 168 886 bekannten Träger immer nur eine Seite des Halbleiterwafers für einen Behandlungsvorgang zugänglich.

Die US-A-4 788 994 zeigt eine Halterung für scheibenförmige Gegenstände, welche die Behandlung der beiden Großflächen des Gegenstandes erlaubt. Die Halterung gemäß der US-A-4 788 994 weist einen um eine Achse drehbaren, sternförmigen Träger auf, an dem mehrere Haltefinger angeordnet sind, die am Außenumfang des Gegenstandes anlegbar sind. Die am Gegenstand anlegbaren Enden der Haltefinger sind in achsialem Abstand von der Ebene des Trägers angeordnet. Bei der aus der US-A-4 788 994 bekannten Halterung wird die Behandlung der dem Träger zugewendeten Großfläche des Gegenstandes von den Armen des sternförmigen Trägers behindert.

Der Erfindung liegt die Aufgabe zugrunde, eine Vorrichtung der eingangs genannten Gattung anzugeben, mit der beide Seiten des scheibenförmigen Gegenstandes für einen Behandlungsvorgang zugänglich sind.

Erfindungsgemäß wird diese Aufgabe mit einer Vorrichtung gelöst, welche die Merkmale des unabhängigen Anspruches 1 aufweist.

Bei der erfindungsgemäßen Vorrichtung sind nicht nur beide Seiten des scheibenförmigen Gegenstandes (Siliziumwafer) für einen Behandlungsvorgang zugänglich, sondern es ist auch von Vorteil, daß der scheibenförmige Gegenstand im axialen Abstand von dem drehbar gelagerten und drehangetriebenen ringförmigen Träger angeordnet ist, weil vom scheibenförmigen Gegenstand abgeschleudertes Behandlungsfluid mit dem drehbaren Träger und dessen Lagerung nicht in Berührung kommt, so daß diese von der Behandlungsfluiden nicht beeinträchtigt, z.B. korrodiert, werden.

Vorteilhafte und bevorzugte Ausführungsformen der erfindungsgemäßen Vorrichtung sind Gegenstand der Unteransprüche.

Weitere Einzelheiten und Vorteile der erfindungsgemäßen Vorrichtung ergeben sich aus der nachstehenden Beschreibung von Ausführungsbeispielen der Erfindung, in welcher auf die angeschlossenen Zeichnungen, in der Ausführungsbeispiele weitestgehend schematisiert dargestellt sind, verwiesen wird. Es zeigt:
Fig. 1 schematisch und im Achsialschnitt eine erste Ausführungsform einer Vorrichtung zum Behandeln scheibenförmiger Gegenstände,
Fig. 2 schematisch und im Schnitt eine zweite Ausführungsform der Vorrichtung zum Behandeln scheibenförmiger Gegenstände,
Fig. 3 eine Ausführungsform der Haltefinger in vergrößertem Maßstab,
Fig. 4 eine Ausführungsform mit verschwenkbaren Haltefingern,
Fig. 5 eine Ausführungsform mit verdrehbaren Haltefingern,
Fig. 5a die Ausführungsform von Fig. 5 in Draufsicht,
Fig. 6 eine Ausführungsform mit Haltefingern mit mechanischer Verriegelung und
Fig. 7 eine andere Ausführungsform der Haltefinger mit mechanischer Verriegelung.

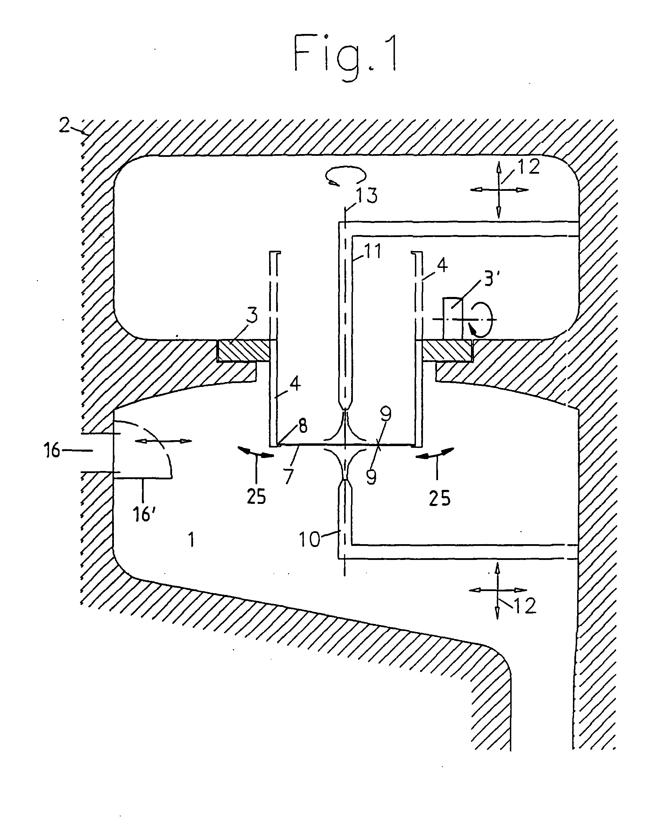

In einer Kammer 1 ist in einem Lager 2 ein als Ring ausgebildeter Träger 3 drehbar gelagert. Der Träger 3 kann durch einen in Fig. 1 durch eine am Träger 3 angreifende Antriebsrolle 3' symbolisierten Antrieb in Drehung mit hoher Drehzahl versetzt werden. Die Kammer 1 kann so wie in Fig. 1 beispielhaft dargestellt, geschlossen ausgebildet sein, wobei einem Absaugkanal 16 oder jedem Absaugkanal 16, wenn mehrere Absaugkanäle 16 vorgesehen sind, ein Verschlußorgan, z.B. eine Klappe 16', zugeordnet sein kann.

Am Innenrand des Trägers 3 sind mehrere (wenigstens drei, jedoch bis zwölf) Haltefinger 4 vorgesehen, die im gezeigtem Ausführungsbeispiel vom Träger 3 nach unten ragen. Die freien Enden 5 der Haltefinger 4 sind abgewinkelt und sind an den Außenumfang 8 eines scheibenförmigen Gegenstandes 7 anlegbar.

Obwohl nicht zwingend erforderlich, kann die Anordnung so getroffen sein, daß die Haltefinger 4 federelastisch am Außenumfang 8 des scheibenförmigen Gegenstandes 7 anlegbar sind. Hiezu können die Haltefinger 4 wenigstens teilweise federelastisch ausgebildet sein. Es ist aber auch möglich, die Haltefinger 4 am Ring 3 verschwenkbar zu lagern (die Verschwenkachse jedes Haltefingers 4 liegt in einer zur Ebene des Trägers 3 parallelen Ebene und ist tangential zum Träger 3 ausgerichtet), wobei die Haltefinger 4 in der am Außenumfang 8 des scheibenförmigen Gegenstandes 7 anliegenden Lage durch eine oder mehrere Federn (im letzteren Fall ist jedem Haltefinger 4 eine Feder zugeordnet) gehalten werden.

Alternativ oder zusätzlich kann eine Maßnahme vorgesehen sein, um die Haltefinger 4 in der am Außenumfang 8 des scheibenförmigen Gegenstandes 7 anliegenden Lage festzulegen, damit sie durch Zentrifugalkräfte nicht nach außen verschwenken.

In Fig. 1 ist schematisch angedeutet, daß die Haltefinger 4 vom Träger 3 auch nach oben weisen können, so daß der scheibenförmige Gegenstand 7 oberhalb des Trägers 3 gehalten wird.

Obwohl grundsätzlich nur eine Düse zum Auftragen eines Behandlungsfluids (Säure zum Ätzen und/oder Waschflüssigkeit zum Spülen von Siliziumwafer) vorgesehen sein kann, sind im gezeigten Ausführungsbeispiel zwei Düsen 10 und 11 vorgesehen, von denen jede einer der Großflächen 9 des scheibenförmigen Gegenstandes 7 zugeordnet ist.

Es ist erkennbar, daß durch die Ausbildung des Trägers 3 als Ring und die Haltefinger 4, die einen Korb bilden, sowohl die Oberseite als auch die Unterseite, also beide Großflächen 9 des scheibenförmigen Gegenstandes 7 für eine Behandlung mit Behandlungsfluiden frei zugänglich sind.

In einer bevorzugten Ausführungsform sind die Düsen 10 und 11, wie durch die Doppelpfeile 12 in Fig. 1 symbolisiert, relativ zum scheibenförmigen Gegenstand 7 verstellbar. Die Verstellbarkeit kann dadurch erreicht werden, daß die (nicht gezeigte) Halterung der Düsen 10 und 11 um eine zur Drehachse 13 des Korbes (Träger 3 und Haltefinger 4) parallele, jedoch von dieser einen Abstand aufweisende Achse verschwenkt werden. Zusätzlich oder alternativ kann die Halterung auch so ausgeführt sein, daß sie die Düsen 10 und 11 so verstellt, daß sie sich entlang eines Durchmessers des scheibenförmigen Gegenstandes 7 bewegen.

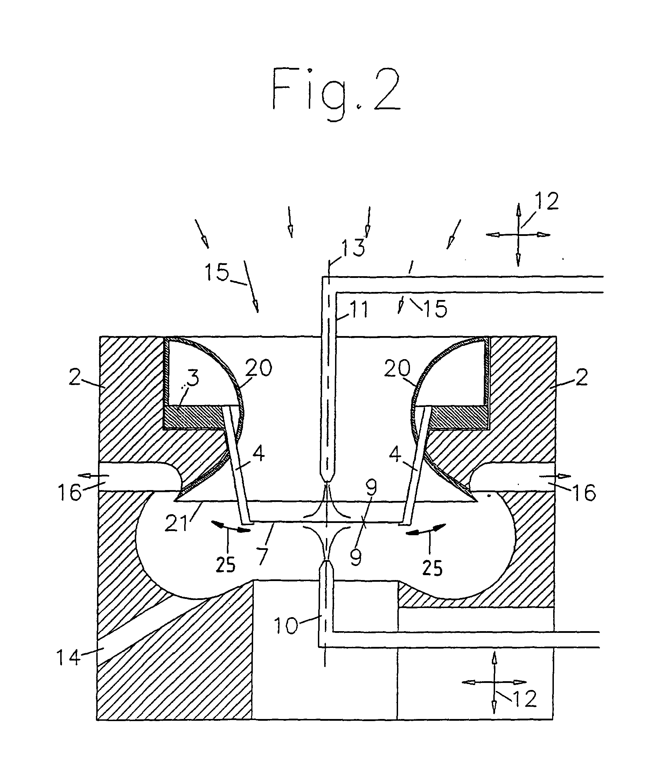

Aus Fig. 1 ist weiters erkennbar, daß vom scheibenförmigen Gegenstand 7 abgeschleudertes Behandlungsfluid, ohne den Träger 3 und dessen Lagerung 2 zu beeinträchtigen, in der Kammer 1 aufgefangen und aus dieser über den Abzug 14 (Fig. 2) entsorgt werden kann.

Die Haltefinger 4, die vorzugsweise voneinander unabhängig an den Außenumfang 8 des scheibenförmigen Gegenstandes 7 anlegbar sind (um von der genauen Kreisform abweichende Umfangskonturen des scheibenförmigen Gegenstandes auszugleichen), können anstelle der abgebogenen Enden auch z.B. V-förmige Ausnehmungen aufweisen, in die der Rand 8 des scheibenförmigen Gegenstandes 7 eingreift. Diese Ausführungsform ist auch für vom Träger 3 nach oben weisende Haltefinger 4 geeignet.

Bei der in Fig. 2 gezeigten Ausführungsform der erfindungsgemäßen Vorrichtung zum Behandeln scheibenförmiger Gegenstände ist der Träger 3 radial nach innen durch eine torusförmige Verkleidung 20 geschützt, so daß allenfalls verwirbeltes Behandlungsfluid nicht zum Träger 3 und dessen Lagerung im Lager 2 gelangen kann.

Der untere, freie Rand 21 der Verkleidung 20 befindet sich oberhalb des zu behandelnden Gegenstandes 7, ist jedoch unterhalb der Absaugkanäle 16, durch die in Richtung der Pfeile 15 zugeführte Luft oder Stickstoff wieder abgezogen werden kann, angeordnet.

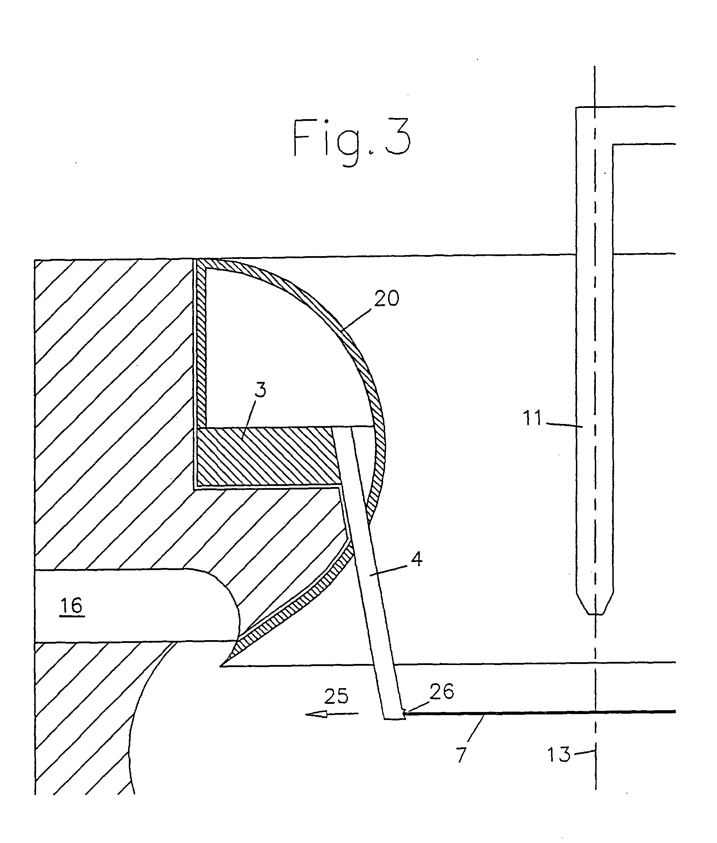

Ausführungsbeispiele für Haltefinger 4 sind in den Fig. 3 bis 7 gezeigt.

Bei der in Fig. 3 gezeigten Ausführungsform sind die wenigstens drei Haltefinger 4, die am Träger 3 befestigt sind, zur Achse 13 schräg gestellt, so daß sie von oben nach unten aufeinander zu laufen.

Die Haltefinger 4 der verschiedenen Ausführungsformen (Fig. 1-3, 6 und 7) sind beispielsweise selbst elastisch ausgebildet, so daß sie beim Einsetzen eines scheibenförmigen Gegenstandes 7, das beispielsweise mit Hilfe eines Manipulators erfolgt, in Richtung des Pfeiles 25 radial nach außen ausweichen können und sich dann unter ihrer Federkraft an den Außenumfang 8 des scheibenförmigen Gegenstandes 7 anlegen. Um den scheibenförmigen Gegenstand 7 am freien Ende der Haltefinger 4 sicher festzulegen, sind an den freien Enden der Haltefinger 4 nach innen offene V-förmige Aussparungen 26 vorgesehen, in welchen der Außenumfang 8 des scheibenförmigen Gegenstandes 7 aufgenommen ist.

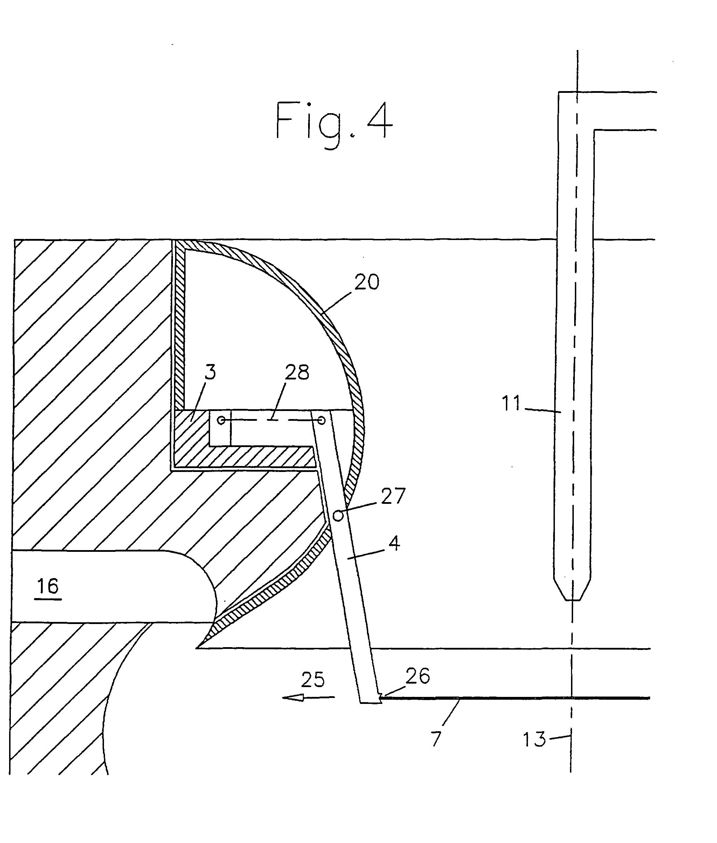

Bei der in Fig. 4 gezeigten Ausführungsform sind die Haltefinger 4 um Lager 27, die beispielsweise an der Verkleidung 20 oder an Verlängerungen des Trägers 3 vorgesehen ist, verschwenkbar gelagert und werden oberhalb der Lager 27 durch ein elastisches Element 28, beispielsweise eine Schraubenzugfeder od. dgl., die am Träger 3 oder an einem mit diesem verbundene Teil verbunden ist, so belastet, daß ihre freien Enden mit der V-förmigen Aussparung 26 radial nach innen verschwenkt werden. Beim Einsetzen eines scheibenförmigen Gegenstandes 7 in den Korb verschwenken die Haltefinger 4 um ihre Lager 27, wobei sich ihre freien Enden in Richtung des Pfeiles 25 nach außen bewegen, so daß der scheibenförmige Gegenstand 7 dann von den Haltefingern 4 unter der Wirkung der Zugfedern 28 sicher gehalten wird.

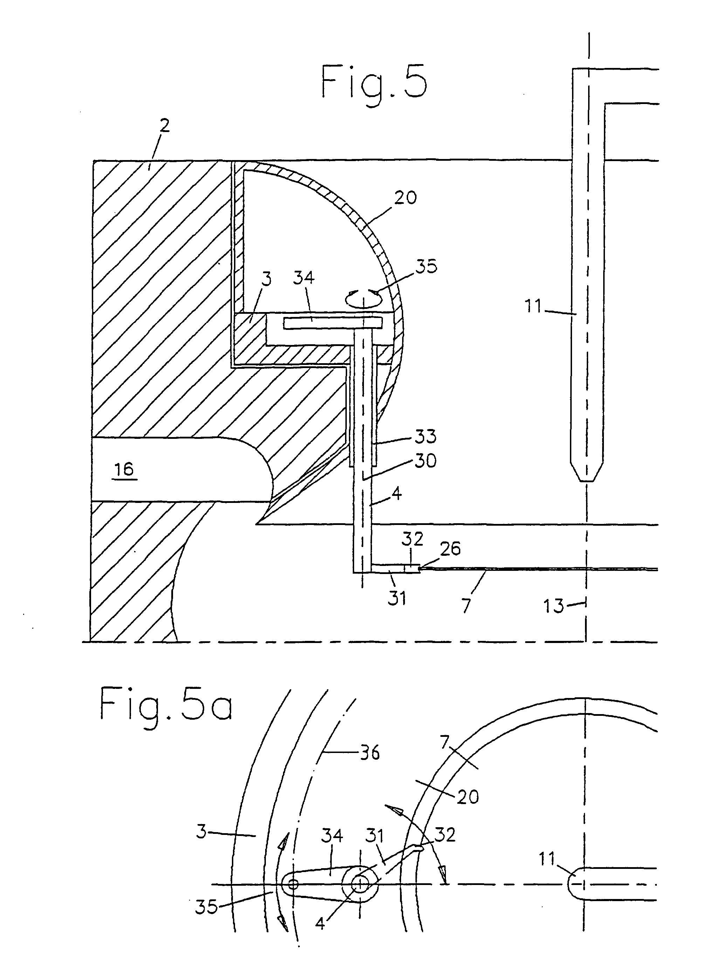

Bei der in Fig. 5 und 5a gezeigten Ausführungsform sind die Haltefinger 4 um Achsen 30, die zur Achse 13, um welche der Träger 3 verdrehbar ist, vorzugsweise parallel ausgerichtet sind, verschwenkbar in Hülsen 33, die mit dem Träger 3 verbunden sind, gelagert. Die Haltefinger 4 tragen an ihren unteren Enden Arme 31, deren freie Enden 32 mit V-förmigen Aussparungen 26 versehen sind, in welche der scheibenförmige Gegenstand 7 mit seinem Außenumfang 8 eingreift. Zum Verschwenken der Arme 31 der Haltefinger 4 um die Achse 30 in Richtung des Doppelpfeiles 35 sind an den innerhalb der Abdeckung 20 vorgesehenen Raum liegenden Enden der Haltefinger 4 mit den Haltefingern 4 verbundene Lenker 34 vorgesehen. Den Lenkern 34 ist eine beispielsweise für alle Haltefinger 4 gemeinsame Antriebsvorrichtung zugeordnet. Die Ausbildung der Haltefinger 4 gemäß Fig. 5 ist nochmals in Draufsicht in Fig. 5a gezeigt, in der auch ein gemeinsames Betätigungsorgan 36 gezeigt ist.

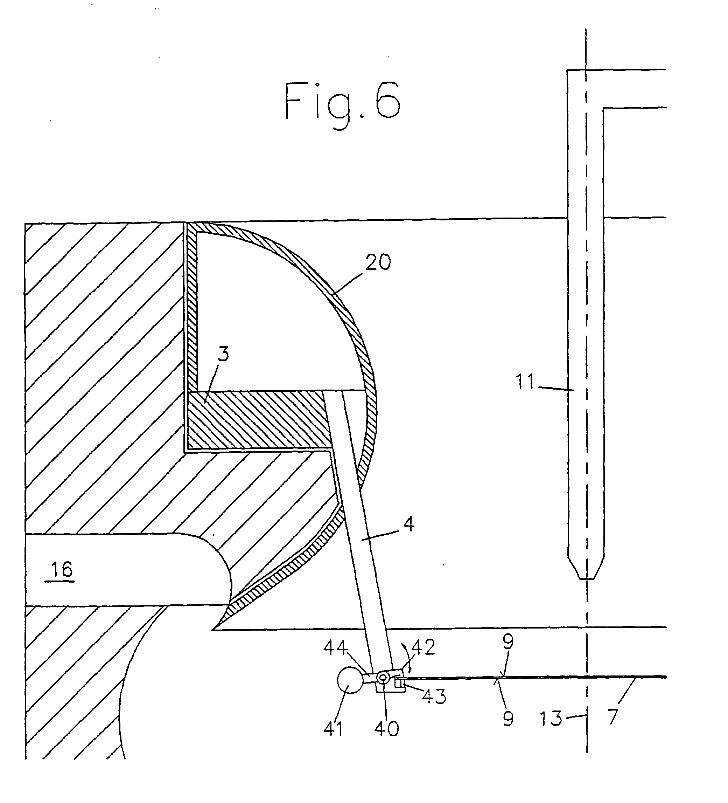

Bei der in Fig. 6 gezeigten Ausführungsform der Haltefinger 4 sind am Bereich der freien Enden der Haltefinger 4 um Achsen 40 verschwenkbare, beispielsweise hakenförmig ausgebildete, Niederhalter 42 vorgesehen, welche sich von oben her an dem auf Stützfingern (Stifte) 43 aufliegenden, scheibenförmigen Gegenstand 7 anlegen, wenn die Vorrichtung in Betrieb ist, d.h. sich der Träger 3 dreht. Wenn sich der Träger 3 dreht, werden die Niederhalter 42 durch ein mit ihnen über einen Hebelarm 44 starr verbundenes Gewicht 41 nach unten in Anlage an die obere Großfläche 9 des Gegenstandes 7 gedrückt, so daß der scheibenförmige Gegenstand 7 zwischen den Stiften 43 und den Niederhaltern 42 geklemmt ist.

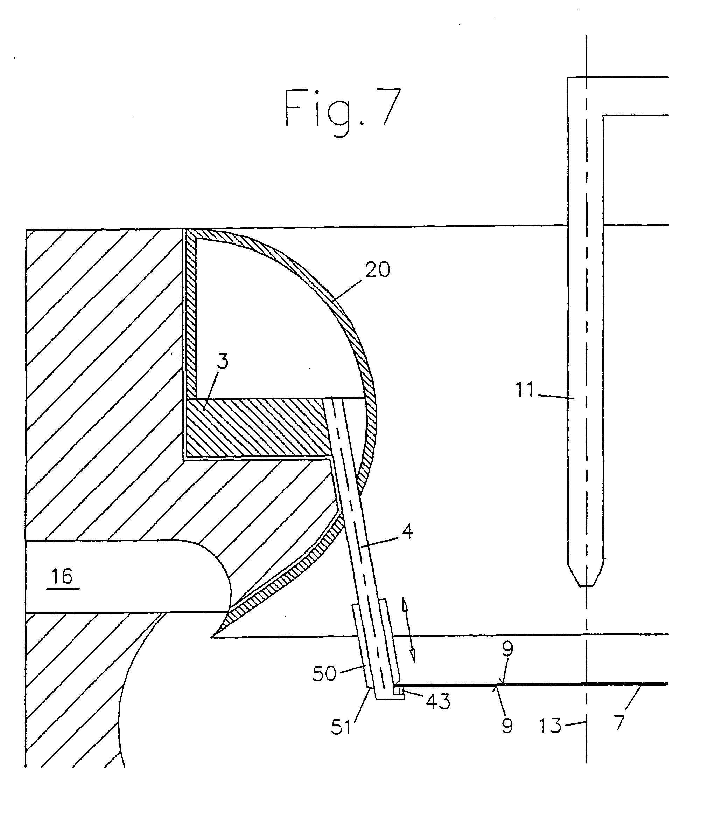

Bei der in Fig. 7 gezeigten Ausführungsform sind an den Haltefingern 4 in ihrer Längsrichtung verschiebbare Hülsen 50 vorgesehen, die mit ihren unteren Endflächen 51 gegen die obere Großfläche 9 des scheibenförmigen Gegenstandes 7 aufliegen, so daß dieser gegen die Stifte 43 am freien Ende der Haltefinger 4 gehalten wird. Die Stirnfläche 51 der Hülsen 50 kann die Form eines Kegelstumpfmantels haben, so daß die Hülse 50 ausschließlich am äußersten Rand des scheibenförmigen Gegenstandes 7 anliegt.

Zusammenfassend kann die Erfindung beispielsweise wie folgt dargestellt werden:

In einer Kammer 1 ist ein Korb, der von einem als Ring ausgebildeten Träger 3 und Haltefingern 4 gebildet wird, drehbar gelagert. Durch Drehen des Korbes kann ein von den Haltefingern 4 im achsialen Abstand vom Ring 3 gehaltener scheibenförmiger Gegenstand 7 in Drehung versetzt werden vorzugsweise ist sowohl der oberen als auch der unteren Großfläche 9 des Gegenstandes 7 eine Düse 10 und 11 zugeordnet, aus welcher ein Behandlungsfluid auf den Gegenstand 7 aufgebracht werden kann.

## Patentansprüche

1. Vorrichtung zum Behandeln scheibenförmiger Gegenstände (7) mit einem Behandlungsfluid, mit einer in einer Kammer (1) angeordneten, drehbaren Halterung (3, 4) für den scheibenförmigen Gegenstand (7) und mit wenigstens einer Düse (10, 11) zum Aufbringen des Behandlungsfluids auf den scheibenförmigen Gegenstand (7), wobei die Halterung für den scheibenförmigen Gegenstand einen in der Vorrichtung um eine Achse (13) drehbar gelagerten Träger (3) aufweist, wobei an dem Träger (3) mehrere Haltefinger (4) vorgesehen sind, die am Außenumfang des scheibenförmigen Gegenstandes (7) anlegbar sind, und wobei die am Außenumfang des scheibenförmigen Gegenstandes (7) anlegbaren Enden der Haltefinger (4) im Abstand von der Ebene des Trägers (3) angeordnet sind, **dadurch gekennzeichnet, daß** der Träger (3) ein Ring ist, der sowohl die Oberseite als auch die Unterseite des scheibenförmigen Gegenstandes (7) frei zugänglich läßt.

2. Vorrichtung nach Anspruch 1, **dadurch gekennzeichnet, daß** die Haltefinger (4) elastisch am Außenumfang des scheibenförmigen Gegenstandes (7) anlegbar sind.

3. Vorrichtung nach Anspruch 2, **dadurch gekennzeichnet, daß** die Haltefinger (4) federelastisch ausgebildet sind.

4. Vorrichtung nach Anspruch 2, **dadurch gekennzeichnet, daß** die Haltefinger (4) im Träger (3) verschwenkbar gelagert und unter der Wirkung wenigstens einer Feder (28) stehen, welche die am scheibenförmigen Gegenstand (7) anlegbaren Enden der Haltefinger (4) radial nach innen belasten.

5. Vorrichtung nach einem der Ansprüche 1 bis 4, **dadurch gekennzeichnet, daß** die am Außenumfang des scheibenförmigen Gegenstandes (7) anlegbaren Enden (5) der Haltefinger (4) abgewinkelt sind.

6. Vorrichtung nach einem der Ansprüche 1 bis 5, **dadurch gekennzeichnet, daß** die am scheibenförmigen Gegenstand (7) anlegbaren Enden der Haltefinger (4) eine Aussparung (26) aufweisen, in die der Umfangsrand des scheibenförmigen Gegenstandes (7) eingreift.

7. Vorrichtung nach einem der Ansprüche 1 bis 6, **dadurch gekennzeichnet, daß** die Haltefinger (4) vom Träger (3) nach unten abstehen.

8. Vorrichtung nach einem der Ansprüche 1 bis 6, **dadurch gekennzeichnet, daß** die Haltefinger (4) vom Träger (3) nach oben abstehen.

9. Vorrichtung nach einem der Ansprüche 1 bis 8, **dadurch gekennzeichnet, daß** die wenigstens eine Düse (10, 11) zum Aufbringen des Behandlungsfluids auf eine der Großflächen (9) des scheibenförmigen Gegenstandes (7) ausgehend von einer Stellung, in der die Düse (10, 11) in der Drehachse (13) des Trägers (3) angeordnet ist, durch Verschwenken der Düsenhalterung bis zum Umfangsrand des scheibenförmigen Gegenstandes (7) verstellbar ist.

10. Vorrichtung nach Anspruch 9, **dadurch gekennzeichnet, daß** die Schwenkachse der Düsenhalterung parallel zur Drehachse (13) des Trägers (3) ausgerichtet und von der Achse (13) des Trägers (3) einen Abstand aufweist.

11. Vorrichtung nach Anspruch 10, **dadurch gekennzeichnet, daß** die Schwenkachse der Düsenhalterung außerhalb des Trägers (3) angeordnet ist.

12. Vorrichtung nach einem der Ansprüche 1 bis 11, **dadurch gekennzeichnet, daß** je eine Düse (10, 11) der Oberseite und der Unterseite des scheibenförmigen Gegenstandes (7) zugeordnet ist.

13. Vorrichtung nach einem der Ansprüche 1 bis 12, **dadurch gekennzeichnet, daß** die Düsen (10, 11) entlang eines Durchmessers des scheibenförmigen Gegenstandes (7) verstellbar sind.

14. Vorrichtung nach einem der Ansprüche 1 bis 13, **dadurch gekennzeichnet, daß** der Träger (3) radial nach innen durch eine Abdeckung (20) umgeben ist.

15. Vorrichtung nach einem der Ansprüche 1 bis 14, **dadurch gekennzeichnet, daß** die Abdeckung (20) ein Rotationskörper ist, der sich von einem engsten Bereich in Richtung der Achse (13) sowohl nach oben als auch nach unten hin erweitert.

16. Vorrichtung nach einem der Ansprüche 1 bis 15, **dadurch gekennzeichnet, daß** im Lager (2) für den Träger (3) wenigstens ein Absaugkanal (16) vorgesehen ist.

17. Vorrichtung nach Anspruch 16, **dadurch gekennzeichnet, daß** der Absaugkanal (16) radial nach außen führt.

18. Vorrichtung nach Anspruch 16 oder 17, **dadurch gekennzeichnet, daß** der Absaugkanal (16) in Gebrauchslage der Vorrichtung höher angeordnet ist als der untere freie Rand (21) der Abdeckung (20).

19. Vorrichtung nach einem der Ansprüche 14 bis 18, **dadurch gekennzeichnet, daß** der untere Rand (21) der Abdeckung (20) in Gebrauchslage der Vorrichtung höher angeordnet ist als die an den scheibenförmigen Gegenstand (7) anlegbaren Enden der Haltefinger (4).

20. Vorrichtung nach einem der Ansprüche 1 bis 19, **dadurch gekennzeichnet, daß** die Haltefinger (4) an ihren freien Enden eine nach innen offene V-förmige Aussparung (26) aufweisen.

21. Vorrichtung nach einem der Ansprüche 1 bis 20, **dadurch gekennzeichnet, daß** die Haltefinger (4) mit der Drehachse (13) des aus Haltefingern (4) und Träger (3) gebildeten Korbes einen spitzen Winkel einschließen.

22. Vorrichtung nach einem der Ansprüche 4 bis 21, **dadurch gekennzeichnet, daß** die Feder (28) einerseits an dem dem freien Ende der Haltefinger (4), das an den scheibenförmigen Gegenstand (7) anlegbar ist, gegenüberliegenden Ende und anderseits am Träger (3) befestigt ist.

23. Vorrichtung nach einem der Ansprüche 1 bis 22, **dadurch gekennzeichnet, daß** die Haltefinger (4) um mit der Ebene des Trägers (3) einen Winkel einschließende Achsen (30) verschwenkbar am Träger (3) gelagert sind und an ihren unteren Enden Arme (31) tragen, deren freie Enden (32) am Außenrand des scheibenförmigen Gegenstandes (7) anlegbar sind.

24. Vorrichtung nach Anspruch 23, **dadurch gekennzeichnet, daß** die freien Enden (32) der Arme (31) der Haltefinger (4) eine nach innen offene Aussparung (26) aufweisen.

25. Vorrichtung nach Anspruch 23 oder 24, **dadurch gekennzeichnet, daß** die Haltefinger (4) in einer am Träger (3) befestigten Buchse (33) geführt sind.

26. Vorrichtung nach einem der Ansprüche 23 bis 25, **dadurch gekennzeichnet, daß** die Haltefinger (4) an ihrem oberen Ende mit einem Lenker (34) verbunden sind, dem eine für alle Haltefinger (4) vorzugsweise gemeinsame Antriebsvorrichtung (36) zum Verschwenken (35) der Haltefinger (4) zugeordnet ist.

27. Vorrichtung nach einem der Ansprüche 23 bis 26, **dadurch gekennzeichnet, daß** die Schwenkachse (30) der Haltefinger (4) zur Drehachse (13) des Trägers (3) parallel ausgerichtet ist.

28. Vorrichtung nach einem der Ansprüche 1 bis 27, **dadurch gekennzeichnet, daß** an den freien Enden der Haltefinger (4) an der Unterseite (9) des scheibenförmigen Gegenstandes anliegende Stifte (43) vorgesehen sind und daß am Haltefinger (4) eine verschwenkbare, von oben an den scheibenförmigen Gegenstand (7) anzulegende Niederhalter (42) befestigt ist.

29. Vorrichtung nach Anspruch 28, **dadurch gekennzeichnet, daß** der Niederhalter (42) am freien Ende des Haltefingers (4) um eine Achse (40) verschwenkbar gelagert ist.

30. Vorrichtung nach Anspruch 28 oder 29, **dadurch gekennzeichnet, daß** mit dem Niederhalter (42) über einen Hebel (44) ein Gewicht (41) verbunden ist.

31. Vorrichtung nach einem der Ansprüche 1 bis 30, **dadurch gekennzeichnet, daß** am Haltefinger (4) verschiebbar eine Hülse (50) vorgesehen ist, welche am Rand des scheibenförmigen Gegenstandes (7) von oben her anlegbar ist und dabei gegen die an die Unterseite des scheibenförmigen Gegenstandes (7) anlegende Auflager (43) drückt.

32. Vorrichtung nach Anspruch 31, **dadurch gekennzeichnet, daß** die Auflager von unten nach oben weisende Stifte (43) sind.

33. Vorrichtung nach einem der Anspruch 31 oder 32, **dadurch gekennzeichnet, daß** die am scheibenförmigen Gegenstand (7) anliegende Stirnfläche (51) der Hülse (50) kegelstumpfmantelförmig ist.

## Claims

1. Device for treating wafer-shaped objects (7) with a treatment fluid, said device having, disposed in a chamber (1), a rotary mounting (3, 4) for the wafer-shaped object (7), and having at least one nozzle (10, 11) to apply the treatment fluid to the wafer-shaped object (7), wherein the mounting for the wafer-shaped object has a carrier (3) mounted in the device so as to be rotatable about an axis (13), wherein a plurality of retaining fingers (4) is provided on the carrier (3), which fingers can be laid against the outer periphery of the wafer-shaped object (7), and wherein the ends of the retaining fingers (4) which can be laid against the outer periphery of the wafer-shaped object (7) are disposed at a distance from the plane of the carrier (3), **characterised in that** the carrier (3) is a ring which leaves both the upper side and the lower side of the wafer-shaped object freely accessible.

2. Device according to claim 1, **characterised in that** the retaining fingers (4) can be laid resiliently against the outer periphery of the wafer-shaped object (7).

3. Device according to claim 2, **characterised in that** the retaining fingers (4) are designed spring-elastic.

4. Device according to claim 2, **characterised in that** the retaining fingers (4) are swivel-mounted in the carrier (3) and are under the action of at least one spring (28) which loads radially inwards the ends of the retaining fingers (4) which can be laid against the wafer-shaped object (7).

5. Device according to one of claims 1 to 4, **characterised in that** the ends (5) of the retaining fingers (4) which can be laid against the outer periphery of the wafer-shaped object (7) are angled.

6. Device according to one of claims 1 to 5, **characterised in that** the ends of the retaining fingers (4) which can be laid against the wafer-shaped object (7) have a recess (26) in which the peripheral edge of the wafer-shaped object (7) engages.

7. Device according to one of claims 1 to 6, **characterised in that** the retaining fingers (4) project downwards from the carrier (3).

8. Device according to one of claims 1 to 6, **characterised in that** the retaining fingers (4) project upwards from the carrier (3).

9. Device according to one of claims 1 to 8, **characterised in that** the at least one nozzle (10, 11) for applying the treatment fluid to one of the large surfaces (9) of the wafer-shaped object (7), starting from a position in which the nozzle (10, 11) is disposed in the rotational axis (13) of the carrier, is adjustable by swivelling the nozzle mounting up to the peripheral edge of the wafer-shaped object (7).

10. Device according to claim 9, **characterised in that** the swivel axis of the nozzle mounting is aligned parallel to the rotational axis (13) of the carrier (3) and at a spacing from said axis (13).

11. Device according to claim 10, **characterised in that** the swivel axis of the nozzle mounting is disposed outside the carrier (3).

12. Device according to one of claims 1 to 11, **characterised in that** one nozzle (10, 11) each is allocated to the upper side and the lower side of the wafer-shaped object (7).

13. Device according to one of claims 1 to 12, **characterised in that** the nozzles (10, 11) are adjustable along one diameter of the wafer-shaped object (7).

14. Device according to one of claims 1 to 13, **characterised in that** the carrier (3) is surrounded radially inwards by a cover (20).

15. Device according to one of claims 1 to 14, **characterised in that** the cover (20) is a body of revolution which widens in the direction of axis (13) both towards the top and towards the bottom.

16. Device according to one of claims 1 to 15, **characterised in that** at least one suction channel (16) is provided in the bearing (2) for the carrier (3).

17. Device according to claim 16, **characterised in that** the suction channel (16) leads radially outwards.

18. Device according to claim 16 or 17, **characterised in that,** when the device is in its position of use, the suction channel (16) is disposed higher than the lower free edge (21) of the cover (20).

19. Device according to one of claims 14 to 18, **characterised in that,** when the device is in its position of use, the lower edge (21) of the cover (20) is disposed higher than the ends of the retaining fingers (4) which can be laid against the wafer-shaped object (7).

20. Device according to one of claims 1 to 19, **characterised in that** the retaining fingers (4) have at their free ends a V-shaped recess (26) which is open towards the inside.

21. Device according to one of claims 1 to 20, **characterised in that** the retaining fingers (4) enclose an acute angle with the rotational axis (13) of the cage formed from retaining fingers (4) and carrier (3).

22. Device according to one of claims 4 to 21, **characterised in that** the spring is secured at one end to the free end of the retaining fingers (4), which is to be laid against the wafer-shaped object (7), and at the other end to the carrier (3).

23. Device according to one of claims 1 to 22, **characterised in that** the retaining fingers (4) are mounted on the carrier (3) pivotable about axes (30) enclosing an angle with the plane of the carrier (3), and bear at their lower ends arms (31), the free ends (32) of which can be laid against the outer periphery of the wafer-shaped object (7).

24. Device according to claim 23, **characterised in that** the free ends (32) of the arms (31) of the retaining fingers (4) have an inwardly open recess (26).

25. Device according to claim 23 or 24, **characterised in that** the retaining fingers (4) are guided in a sleeve (33) secured to the carrier (3).

26. Device according to one of claims 23 to 25, **characterised in that** the retaining fingers (4) are connected at their upper end with a connecting rod (34), with which a drive device (36) for swivelling (35) the retaining fingers (4) is associated which is preferably common to all the retaining fingers (4).

27. Device according to one of claims 23 to 26, **characterised in that** the swivel axis (30) of the retaining fingers (4) is aligned parallel to the rotational axis (13) of the carrier (3).

28. Device according to one of claims 1 to 27, **characterised in that** at the free ends of the retaining fingers (4), pins (43) are provided which abut against the lower side (9) of the wafer-shaped object and **in that** a swivelling holding down-device (42), which can be laid from above against the wafer-shaped object (7), is secured to the retaining finger (4).

29. Device according to claim 28, **characterised in that** the holding-down device (42) is mounted on the free end of the retaining finger (4) pivotable about an axis (40).

30. Device according to claim 28 or 29, **characterised in that** a weight (41) is connected to the holding-down device (42) via a lever (44).

31. Device according to one of claims 1 to 30, **characterised in that** a sleeve (50) is provided which is displaceable on the retaining finger (4) and can be laid from above against the edge of the wafer-shaped object (7) and in so doing presses against the supports (43) adjoining the lower side of the wafer-shaped object (7).

32. Device according to claim 31, **characterised in that** the supports are pins (43) pointing from the bottom upwards.

33. Device according to one of claims 31 or 32, **characterised in that** the sleeve (50) face (51) adjoining the wafer-shaped object (7) has the shape of the jacket of a truncated cone.

## Revendications

1. Dispositif pour le traitement d'objets (7) en forme de tranches au moyen d'un fluide de traitement, comprenant un moyen de support (3, 4) tournant pour l'objet (7) en forme de tranche, qui est disposé dans une chambre (1), ainsi qu'au moins une buse (10, 11) pour l'application du fluide de traitement sur l'objet (7) en forme de tranche, le moyen de support pour l'objet (7) en forme de tranche comportant un élément de support (3), qui est monté tournant autour d'un axe (13) dans le dispositif, plusieurs doigts de maintien (4) qui peuvent être appliqués sur le bord périphérique de l'objet (7) en forme de tranche étant prévus sur l'élément de support (3) et les extrémités des doigts de maintien (4) applicables sur le bord périphérique de l'objet (7) en forme de tranche étant disposées à distance du plan de l'élément de support (3), **caractérisé en ce que** l'élément de support (3) est un anneau qui laisse l'accès libre aussi bien à la face supérieure qu'à la face inférieure de l'objet (7) en forme de tranche.

2. Dispositif selon la revendication 1, **caractérisé en ce que** les doigts de maintien (4) sont appliqués de manière élastique sur le bord périphérique de l'objet (7) en forme de tranche.

3. Dispositif selon la revendication 2, **caractérisé en ce que** les doigts de maintien (4) sont élastiques.

4. Dispositif selon la revendication 2, **caractérisé en ce que** les doigts de maintien (4) sont montés pivotants dans l'élément de support (3) et sont soumis à l'action d'un ressort (28), qui sollicite radialement en direction de l'intérieur les extrémités des doigts de maintien (4) applicables sur l'objet (7) en forme de tranche.

5. Dispositif selon une des revendications 1 à 4, **caractérisé en ce que** les extrémités (5) des doigts de maintien (4) applicables sur le bord périphérique de l'objet (7) en forme de tranche sont coudées.

6. Dispositif selon une des revendications 1 à 5, **caractérisé en ce que** les extrémités (5) des doigts de maintien (4) applicables sur le bord périphérique de l'objet (7) en forme de tranche présentent un évidement (26) dans lequel pénètre le bord périphérique de l'objet (7) en forme de tranche.

7. Dispositif selon une des revendications 1 à 6, **caractérisé en ce que** les doigts de maintien (4) font saillie vers le bas par rapport à l'élément de support (3).

8. Dispositif selon une des revendications 1 à 6, **caractérisé en ce que** les doigts de maintien (4) font saillie vers le haut par rapport à l'élément de support (3).

9. Dispositif selon une des revendications 1 à 8, **caractérisé en ce que** la buse (10, 11), au nombre d'au moins une, pour l'application du fluide de traitement sur l'une des faces (9) de l'objet (7) en forme de tranche peut être déplacée par pivotement du porte-buse depuis une position dans laquelle la buse (10, 11) est située sur l'axe de rotation (13) de l'élément de support (3) jusqu'au bord périphérique de l'objet (7) en forme de tranche.

10. Dispositif selon la revendication 9, **caractérisé en ce que** l'axe de pivotement du porte-buse est parallèle à l'axe de rotation (13) de l'élément de support (3) et est disposé à distance dudit axe de rotation (13) dudit élément de support (3).

11. Dispositif selon la revendication 10, **caractérisé en ce que** l'axe de pivotement du porte-buse est disposé en dehors de l'élément de support (3).

12. Dispositif selon une des revendications 1 à 11, **caractérisé en ce qu'**une buse (10, 11) est associée respectivement à la face supérieure et à la face inférieure de l'objet (7) en forme de tranche.

13. Dispositif selon une des revendications 1 à 12, **caractérisé en ce que** les buses (10, 11) peuvent être déplacées le long d'un diamètre de l'objet (7) en forme de tranche.

14. Dispositif selon une des revendications 1 à 13, **caractérisé en ce que** l'élément de support (3), radialement vers l'intérieur, est entouré d'un capot (20).

15. Dispositif selon une des revendications 1 à 14, **caractérisé en ce que** le capot (20) est un corps de révolution qui, à partir d'une zone très étroite dans la direction de l'axe (13), s'évase vers le haut et vers le bas,

16. Dispositif selon une des revendications 1 à 15, **caractérisé en ce qu'**il est prévu au moins un canal d'aspiration (16) dans le palier (2) de l'élément de support (3).

17. Dispositif selon la revendication 16, **caractérisé en ce que** le canal d'aspiration (16) mène radialement à l'extérieur,

18. Dispositif selon la revendication 16 ou 17, **caractérisé en ce que** le canal d'aspiration (16), dans la position d'utilisation du dispositif est disposé plus haut que le bord libre inférieur (21) du capot (20).

19. Dispositif selon une des revendications 14 à 18, **caractérisé en ce que** le bord inférieur (21) du capot (20), dans la position d'utilisation, est disposé plus haut que les extrémités des doigts de maintien (4) applicables sur l'objet (7) en forme de tranche.

20. Dispositif selon une des revendications 1 à 19, **caractérisé en ce que** les doigts de maintien (4), à leur extrémité libre, présentent un évidement (26) en forme de V, ouvert en direction de l'intérieur.

21. Dispositif selon une des revendications 1 à 20, **caractérisé en ce que** les doigts de maintien (4) forment un angle aigu avec l'axe de rotation (13) du panier formé des doigts de maintien (4) et de l'élément de support (3)

22. Dispositif selon une des revendications 4 à 21, **caractérisé en ce que** le ressort (28) est fixé, d'un côté à l'extrémité opposée à l'extrémité libre des doigts de maintien (4), applicable sur l'objet (7) en forme de tranche, et de l'autre sur l'élément de support (3).

23. Dispositif selon une des revendications 1 à 22, **caractérisé en ce que** les doigts de maintien (4) sont montés pivotants sur l'élément de support (3) autour d'axes (30), qui forment un angle avec le plan de l'élément de support (3), et portent à leur extrémité inférieure des bras (31), dont les extrémités libres (32) peuvent être appliquées sur le bord périphérique de l'objet (7) en forme de tranche.

24. Dispositif selon revendication 23, **caractérisé en ce que** les extrémités libres (32) des bras (31) des doigts de maintien (4) présentent un évidement (26) ouvert en direction de l'intérieur.

25. Dispositif selon la revendication 23 ou 24, **caractérisé en ce que** les doigts de maintien (4) sont guidés dans une douille (33) fixée à l'élément de support (3).

26. Dispositif selon une des revendications 23 à 25, **caractérisé en ce que** les doigts de maintien (4), à leur extrémité supérieure sont liés à un levier (34), auquel est associé un dispositif d'entraînement (36), de préférence commun à tous les doigts de maintien (4), aux fins de faire pivoter (35) lesdits doigts de maintien (4).

27. Dispositif selon une des revendications 23 à 26, **caractérisé en ce que** l'axe de rotation (30) des doigts de maintien (4) est parallèle à l'axe de rotation (13) de l'élément de support (3).

28. Dispositif selon une des revendications 1 à 27, **caractérisé en ce qu'**il est prévu aux extrémités libres des doigts de maintien (4) des tiges (43) qui sont en contact avec la face inférieure (9) de l'objet (7) en forme de tranche et **en ce que** sur le doigt de maintien (4) est fixé un élément de bridage (42) pivotant, qui est appliqué par le dessus sur l'objet (7) en forme de tranche.

29. Dispositif selon la revendication 28, **caractérisé en ce que** l'élément de bridage (42) est monté pivotant autour d'un axe (40) à l'extrémité libre du doigt de maintien (4).

30. Dispositif selon la revendication 28 ou 29, **caractérisé en ce qu'**un poids (41) est lié à l'élément de bridage (42) par l'intermédiaire d'un levier (44).

31. Dispositif selon une des revendications 1 à 30, **caractérisé en ce qu'**il est prévu sur le doigt de maintien (4), une douille coulissante (50) qui peut être appliquée par le dessus sur le bord de l'objet (7) en forme de tranche et exerce une pression sur l'appui (43) appliqué contre la face inférieure de l'objet (7) en forme de tranche.

32. Dispositif selon la revendication 31, **caractérise en ce que** l'appui est formé de tiges (43) qui s'étendent du bas vers le haut.

33. Dispositif selon une des revendications 31 ou 32, **caractérisé en ce que** la face frontale (51) de la douille (50) en appui sur l'objet (7) en forme de tranche a une forme de tronc de cône.
